# EUROPÄISCHE PATENTSCHRIFT

(11) **EP 2 327 286 B1**
(45) Veröffentlichungstag und Bekanntmachung des Hinweises auf die Patenterteilung: **17.02.2016**
(21) Anmeldenummer: 09781158.2
(22) Anmeldetag: 28.07.2009
(51) Int. Cl.: H05K 7/20

(54) **SCHALTUNGSGEHÄUSE MIT WÄRMEKOPPLUNGSELEMENT**
CIRCUIT HOUSING HAVING A HEAT COUPLING ELEMENT
BOÎTIER DE CIRCUIT AVEC ÉLÉMENT DE COUPLAGE THERMIQUE

(30) Priorität: 15.09.2008 DE 102008042099
(43) Veröffentlichungstag der Anmeldung: 01.06.2011
(73) Patentinhaber: Robert Bosch GmbH, 70442 Stuttgart (DE)
(72) Erfinder: LISCHECK, Andre, 71665 Vaihingen/Enz (DE); STEIN, Juergen, 75428 Illingen (DE)
(86) Internationale Anmeldenummer: PCT/EP2009/059704
(87) Internationale Veröffentlichungsnummer: WO 2010/028906

(56) Entgegenhaltungen:
- WO-A-01/41521
- DE-A1- 4 224 720
- JP-A- 11 015 566

## Beschreibung

### Stand der Technik

Die Erfindung geht aus von Schaltungen, insbesondere Leistungsschaltungen, deren erzeugte Wärme von Kühlelementen abgeführt werden. Leistungsbauteile einer Schaltung sehen eine Oberfläche vor, über die Wärme an daran befestigte Kühlkörper übertragen wird, um die Wärme in die Umgebung abzuleiten.

Leistungsbauteile wie MOSFETs, IGBTs, Triacs, Thyristoren und andere sind zur Steuerung hoher Ströme vorgesehen, wobei es sich nicht vermeiden lässt, dass durch den Innenwiderstand des Leistungsbauteils im angeschlossenen Zustand elektrische Energie in Wärme umgesetzt wird. Insbesondere wenn hohe Leistungen bei geringen Betriebsspannungen abgefragt werden, fließen hohe Ströme, die ein zum Teil aufwändiges Wärmemanagement erfordern. Zum Ableiten der Wärme werden Kühlkörper zur Luftkühlung eingesetzt, die über einen großflächigen Kontakt Wärme von einem Leistungsbauelement abführen. Derartige Kühlkörper haben einen erheblichen Platzbedarf und verursachen bei Herstellungskosten durch zusätzliche Herstellungsschritte sowie Materialkosten. Ferner besteht die Möglichkeit, dass Leistungsbauelemente ihre Wärme an eine darunter liegende Leiterplatte abgeben, auf der sie befestigt sind, wobei die Leiterplatte die Wärme beispielsweise an ein Gehäuse oder an weitere Kühlelemente abgibt. Damit die Leiterplatte in diesem Fall ausreichend Wärme überträgt, müssen die Metalllagen der Leitplatte relativ dick vorgesehen sein oder zusätzliche Wärmeleitelemente umfassen, die den Platzbedarf und insbesondere die Herstellungskosten erhöhen. Zudem werden durch die Leiterplatte weitere Bauteile erwärmt.

Für SMD-Leistungsbauteile bestehen grundsätzlich zwei verschiedene Bauformen zur Wärmeableitung: Gehäuse mit einem Wärmeableitungsblech zur Leiterplatte hin (*slug down*), sowie Wärmeableitungsfläche von der Leiterplatte weg, um einen Kühlkörper auf dem Bauelement zu befestigen (*slug up*). Die *slug up*-Variante (Wärmeableitung nach oben von der Leiterplatte weg) wird gemäß dem Stand der Technik zusammen mit einem Kühlkörper ausgeführt, der Kühlrippen aufweisen kann, und der möglichst direkt auf dem Bauteil befestigt ist, so dass das Bauteil zwischen Kühlkörper und Leiterplatte angeordnet ist.

Wie bereits bemerkt, erhöht ein derartiger Kühlkörper den Platzbedarf Insbesondere bei der Ausführung von Schaltungen in geschlossenen Gehäusen leitet der Kühlkörper nur unbefriedigend die Wärme in die Umgebung ab da der Kühlkörper nicht in direktem Kontakt zur Umgebung steht. Dies ist bei der Kapselung von Schaltungen mit Leistungsbauteilen hinsichtlich der Wärmebilanz besonders kritisch. Wie bereits bemerkt, ist ebenso die Kühlung bei *slug down*-Konstruktionen nicht zufrieden stellend, da die Leiterplatte das Leistungsbauteil in geringerem Maße kühlt, insbesondere bei Schaltungen, die in geschlossenen Gehäusen vorgesehen sind.

Die Dokumente WO 01/41521 A, JP 11 015566 A und DE 42 24 720 A1 offenbaren ein Schaltungsgehäuse nach dem Oberbegriff des Anspruchs 1.

### Offenbarung der Erfindung

Die Erfindung erlaubt eine Kühlung von Leistungsbauteilen mit geringeren Kosten und bei geringerem Fertigungsaufwand. Gleichzeitig ermöglicht die Erfindung eine effiziente Kühlung, selbst wenn das Leistungsbauteil in einem geschlossenen Gehäuse angeordnet ist. Als geschlossenes Gehäuse werden hier (hermetisch) abgedichtete Gehäuse, deren Innenraum vollständig von der Umgebung abgetrennt ist, sowie auch Gehäuse bezeichnet, die einen Innenraum umschließen, der zwar mit der Umgebung durch Ausnehmungen oder ähnliches in Kontakt steht, beispielsweise über nicht abgedichtete Gehäusestellen, kleinere Ausnehmungen (bsp. für Wartungszugriffe) oder Schlitze, wobei jedoch keine ausreichende Kühlungsströmung (durch Konvektion o.ä.) von der Umgebung in den Innenraum hinein möglich ist. Mit dem erfindungsgemäßen Schaltungsgehäuse und dem zugehörigen Verfahren können kostspielige Kühlkörper eingespart werden und gleichzeitig die Kühlung erhöht werden. Erfindungsgemäß werden keine separaten Kühlkörper verwendet, so dass die Gefahr eines abfallenden Kühlkörpers und die dadurch resultierende mangelhafte Kühlung nicht besteht. Es können übliche dünne Leiterplatten verwendet werden, die keine besonderen Wärmeleitfähigkeiten aufweisen müssen. Hierdurch lassen sich kostengünstigere Leiterplatten einsetzen, beispielsweise übliche Leiterplatten auf Epoxy- oder Hartpapierbasis oder übliche faserverstärkte Leiterplatten. Insbesondere ermöglicht die Erfindung das Montieren von wärmeleitenden Elementen für mehrere bzw. für alle Leistungsbauteile einer Schaltung gleichzeitig. Vor allem bei komplexen Schaltungen wird dadurch der Herstellungsprozess um zahlreiche Schritte verringert. Erfindungsgemäß erhält das Gehäuse eine Doppelfunktion, d.h. (1) mechanischer Schutz sowie (2) Wärmekontaktelement bzw. Wärmesenke, so dass sich sämtliche Befestigungselemente sowie separate Kühlkörper dadurch einsparen lassen, dass das Gehäuse (oder die Schaltung) entsprechend ausgebildet wird. Durch die Zuordnung der Doppelfunktion ergibt sich ein deutlicher Synergieeffekt, der sich darin äußert, dass sämtliche Herstellungs- und Materialkosten, die mit Kühlkörpern und deren Montage einhergehen, durch die Anwendung der Erfindung entfallen. Neben der oben beschriebenen Doppelfunktion dient das Gehäuse der Abdichtung gegenüber der Umgebung.

Das der Erfindung zugrunde liegende Konzept liegt darin, die in dem Schaltungsgehäuse vorliegende Schaltung direkt mit dem Schaltungsgehäuse zu kühlen, d.h. durch unmittelbare Verbindung der Gehäusewand des Schaltungsgehäuses mit mindestens einem zu kühlenden Bauteil der Schaltung. Dazu wird die zu wählende Schaltung von innen direkt mit dem Gehäuse in wärmeleitenden Kontakt gebracht, beispielsweise durch Aufschieben oder Verschließen des Gehäuses. Da das Gehäuse gleichzeitig dem mechanischen Schutz dient, wird durch das Befestigen der Schaltung in dem Innenraum des Schaltungsgehäuses auch eine Kopplung zwischen Bauteil und Schaltungsgehäuse vorgesehen. Hierzu tritt das zu kühlende Bauteil in unmittelbaren Kontakt mit der Gehäusewand, wobei ein Teil der Gehäusewand als Wärmekopplungselement dient.

Als unmittelbarer Kontakt wird das direkte Anordnen des Bauteils in mechanischen Kontakt mit der Gehäusewand bezeichnet, sowie das Anordnen über Wärmeleitpaste, isolierende, wärmeleitende Schichten, oder über zusätzliche Verbindungselemente, die den Kontakt zwischen Gehäusewand und Bauteil vorsehen. Im Gegensatz hierzu steht die indirekte Verbindung des Bauelements über die Leiterplatte und über Halterungen in dem Gehäuse, wobei eine derartige indirekte Verbindung, wie bereits bemerkt, eine nur ungenügende Wärmeleitung vorsieht.

Erfindungsgemäß umfasst somit das Schaltungsgehäuse ein Wärmekopplungselement sowie eine Befestigungseinrichtung zur Befestigung der Schaltung, wobei das Wärmekopplungselement einen Teil der Gehäusewand bildet. Im einfachsten Fall ist ein derartiges Wärmekopplungselement ein Teil der Innenfläche der Gehäusewand, kann jedoch auch Kopplungselemente umfassen, die mit der Gehäusewand verbunden sind oder einteilig mit dieser ausgeführt sind und dem direkten wärmeleitenden Kontakt mit dem Bauelement dienen. Das Wärmekopplungselement ist erfindungsgemäß an der Innenfläche der Gehäusewand angeordnet, so dass automatisch mit dem Einbringen der Schaltung in das Schaltungsgehäuse bzw. mit dem Schließen des Gehäuses auch der unmittelbare Kontakt zwischen Bauteil und Wärmekopplungselement bzw. Gehäusewand vorgesehen wird. Das Wärmekopplungselement ist vorzugsweise komplementär zu dem Bauteil bzw. zu einer Wärmekopplungsfläche des Bauteils ausgestaltet. Im einfachsten Fall sind Wärmekopplungsfläche und Wärmekopplungselement eben, parallel zueinander und in derselben Ebene angeordnet, beispielsweise ein Teil der Innenwand. Die komplementäre Ausgestaltung gewährleistet einen Kontakt zwischen Wärmekopplungselement und Bauteil über eine größere, gemeinsame und vorzugsweise zusammenhängende Fläche. Ferner ermöglicht die komplementäre Ausgestaltung einen homogenen Kontakt, d.h. das Aufeinanderliegen von Bauteiloberfläche und Kopplungselement mit einer relativ homogenen Kraftverteilung, beispielsweise wenn das Bauteil durch eine Federwirkung gegen die Gehäusewand gedrückt wird. Die Federwirkung kann durch einzelne federnde Komponenten vorgesehen werden, die die Leiterplatte gegen die Gehäusewand drücken, beispielsweise aus Metall, Kunststoff oder Ähnlichem, jedoch vorzugsweise wird die Federwirkung durch einen Träger, beispielsweise eine Leiterplatte vorgesehen, auf der die Bauelemente befestigt sind und die durch eine geringfügige Presspassung die Bauelemente kontinuierlich und homogen gegen die Gehäusewand drücken. Mit anderen Worten befestigt die Befestigungseinrichtung die Schaltung bzw. die Bauteile in direktem Kontakt mit der Gehäusewand bzw. mit dem Wärmekopplungselement, wobei die Federwirkung der Schaltung (bzw. eine Federwirkung von Federelementen in der Befestigungseinrichtung) die Bauteile gegen die Gehäusewand drücken.

Anstatt der Federwirkung der Leiterplatte bzw. des Trägers der Bauteile oder in Kombination hiermit kann die Befestigungseinrichtung selbst federnde Elemente aufweisen, beispielsweise eine Führung aus Kunststoff, die unter Belastung geringfügig (elastisch) nachgibt und nachfedert. Insbesondere kann die Federwirkung durch Steckverbindungen wie SMD-Stecker vorgesehen werden, mit den das zu kühlende Bauelement mit der verbleibenden Schaltung bzw. mit der Leiterplatte verbunden ist und das Bauelement federnd hält. Die federnde Halterung des Bauteils dient zum einen, wie bereits bekannt, der elektrischen Kontaktierung, die auch Vibrationen oder Stößen Stand hält, und zum anderen zum Ausüben einer Anpresskraft, mit der die zu kühlende Bauteiloberfläche gegen die Gehäuse wand (gegen das Wärmekopplungselement) federnd geklemmt bzw. angedrückt wird.

Das Wärmekopplungselement, gegen das das Bauteil gedrückt wird, ist vorzugsweise wärmeleitend mit der Gehäusewand verbunden. Dies ist insbesondere dann der Fall, wenn das Wärmekopplungselement ein Teil der Gehäusewand ist bzw. ein Teil der Innenfläche der Gehäusewand, da in diesem Fall Wärmekopplungselement und Gehäusewand selbst einteilig ausgebildet sind. Das Wärmekopplungselement sieht eine Wärmekopplungsfläche vor, auf die das Bauteil gedrückt wird, vorzugsweise eine Wärmeabgabefläche des Bauteils, vorzugsweise aus Metall. Derartige Wärmeabgabeflächen sind vorzugsweise aus wärmeleitendem Metall, wie Kupfer, Aluminium oder Stahl und tragen ferner eine elektrische bzw. elektronische Komponente, beispielsweise einen Leistungshalbleiter im Inneren des Bauteil-Gehäuses. Die Wärmeabgabefläche ist von dem Träger der Bauteile bzw. der Leiterplatte weg orientiert und weist zur Gehäusewand hin. Derartige Wärmeabgabeflächen werden beispielsweise von SMD-Bauteilen in einem Gehäuse mit "slug up"-Wärmeableitung vorgesehen, oder durch Montageflächen auf einer Oberfläche des Bauelements. Ferner sehen Oberflächen von Metallgehäusen von Leistungsbauteilen eine derartige Wärmeabgabefläche vor. Diese wird erfindungsgemäß an das Wärmekopplungselement angekoppelt durch Einschieben der Schaltung oder durch Schließen des Gehäuses.

Wie bereits bemerkt, umfasst eine besonders simple Ausführung der Erfindung ein Wärmekopplungselement, das einen Abschnitt der Innenfläche des Gehäuses umfasst. Diese Innenfläche erstreckt sich vorzugsweise in einer Ebene, die derjenigen Ebene entspricht, in der sich die Wärmeabgabefläche bzw. Wärmeabgabeflächen des Bauteils erstrecken. Vorzugsweise erstrecken sich alle Wärmeabgabeflächen aller Bauteile oder einer Gruppe von Bauteilen entlang der gleichen Ebene. Erstrecken sich Wärmeabgabefläche und Wärmekopplungselement entlang der gleichen Ebene, dann sieht die Oberfläche des Bauteils bzw. die Wärmeabgabefläche des Bauteils zusammen mit dem Abschnitt der Innenfläche eine unmittelbare wärmeleitende Verbindung vor. Alternativ können zwischen Wärmeabgabefläche (d.h. Oberfläche des Bauteils) und Gehäusewand Kontaktelemente vorgesehen sein, die die Bauteilform an die Gehäuseform adaptieren, um eine große gemeinsame Fläche zwischen Bauteil und Gehäuse vorzusehen. Derartige Kontaktelemente können auch wärmeleitende Folien, z.B. aus Kunststoff, Glimmerscheiben, Schichten aus Wärmeleitpaste, eine Kombination hiervon, oder Ähnliches sein, die einen direkten wärmeübertragenden Kontakt zwischen Bauteil und Gehäuse vorsehen. Zudem können die Kontaktelemente Federwirkung aufweisen, um eine homogene Druckkraft zwischen Bauteil und Gehäusewand zu erreichen.

Wie bereits bemerkt, kann das Wärmekopplungselement des Gehäuses einteilig mit der Gehäusewand ausgebildet sein und einen Abschnitt der Innenfläche der Gehäusewand darstellen. Ferner kann das Wärmekopplungselement in einem Abschnitt der Innenfläche der Gehäusewand sein, die in den Innenraum in Richtung des zugeordneten Bauteils hineinragt und so dem Bauteil entgegentritt. Durch derartige, in den Innenraum ragende Abschnitte der Gehäusewandinnenfläche kann die Form der Innenfläche der Gehäusewand den Oberflächen der Bauteile angepasst werden, die die Wärmeabgabefläche bilden. Anstatt einer einteiligen Ausbildung dieser nach innen ragenden Elemente zusammen mit der Gehäusewand können Elemente (in Form von entsprechend geformten Flächen oder Körpern) verwendet werden, die wärmeübertragend an der Gehäusewand befestigt sind.

Das Wärmekopplungselement umfasst vorzugsweise elektrisch isolierende Materialien, beispielsweise Wärmeleitpaste oder wärmeleitende Folie oder eine wärmeleitende Schicht, die zwar eine Wärmeübertragung gewährleisten, jedoch gleichzeitig eine elektrische Isolierung des Bauteils von der Gehäusewand vorsehen. Dies ist insbesondere der Fall, wenn die Gehäusewand als Metallblech oder Metallkörper ausgebildet ist, um für einen guten Wärmetransport zu sorgen. Das Wärmekopplungselement kann zum Teil elektrisch leitend sein, soweit gewährleistet ist, dass dieses eine Schicht elektrisch isolierenden Materials umfasst, die wärmeleitend ist. Derartige Wärmekopplungselemente, die die Gehäusewand zur Wärmeübertragung mit dem Bauteil verbinden, sind zwischen Gehäusewand und Bauteil angeordnet, bzw. zwischen Gehäusewand und Wärmeabgabefläche des Bauteils und grenzen vorzugsweise direkt an das Bauteil sowie an die Gehäusewand an.

Erfindungsgemäß wird das Schaltungsgehäuse mit der darin angeordneten oder befestigten Schaltung vorgesehen, wobei die Schaltung im Wesentlichen einen Träger, beispielsweise eine Leiterplatte, umfasst, sowie Bauteile, die darauf befestigt sind. Wie bereits bemerkt, umfassen die Bauteile Wärmeabgabeflächen, die von dem Träger weg gewandt und zu der Gehäusewand hin gewandt sind, um einen direkten wärmeübertragenden Kontakt mit dem Wärmekopplungselement und somit mit der Gehäusewand vorzusehen. Der direkte bzw. unmittelbare wärmeleitende Kontakt mit dem Wärmekopplungselement kann durch direktes aufeinander Anordnen der Wärmeabgabefläche und des Wärmekopplungselement vorgesehen werden, oder durch Kontaktelemente, wie Wärmeleitpaste, mechanische Kontaktelemente zur Oberflächenadaption des Bauteils an die Gehäusewand (als separate Komponente oder einteilig mit der Gehäusewand bzw. mit dem Bauteil ausgebildet), oder durch wärmeleitende Folien bzw. Schichten (beispielsweise eine Glimmerschicht). Diese Verbindungselemente können einzeln oder auch in Kombination miteinander vorgesehen werden, soweit gewährleistet ist, dass die Wärme unmittelbar vom Bauteil an die Gehäusewand übertragen wird.

Die Befestigungseinrichtung des Schaltungsgehäuses ordnet die Schaltung in dem Innenraum des Schaltungsgehäuses derart an, dass der oben beschriebene unmittelbare Kontakt zwischen Bauteil (Bauteiloberfläche) und Gehäusewand (-Innenfläche) vorgesehen wird. Die Befestigungseinrichtung ist vorzugsweise an dem Schaltungsgehäuse befestigt oder ist mit diesem einteilig ausgebildet (beispielsweise eine Führungsschiene in Form einer Nut). Die Befestigungseinrichtung kann mechanische Träger, Führungselemente, Führungsschienen oder Führungsnuten umfassen, die im Innenraum des Schaltungsgehäuses ausgebildet sind und die die Schaltung im Innenraum des Schaltungsgehäuses halten bzw. tragen. Vorzugsweise wird die Schaltung als Leiterplatte mit Bauelementen vorgesehen, wobei in diesem Fall die Befestigungseinrichtung übliche Befestigungsmittel für Leiterplatten umfasst, beispielsweise Führungsschienen, Führungsnuten oder auch Hülsen, in Kombination mit Schrauben. Ferner können Schnapp- oder Steckverbindungen vorgesehen werden, die Schaltung mit dem Schaltungsgehäuse mechanisch verbinden.

Im Gegensatz zum Stand der Technik, bei dem die Leiterplatte auch als Wärmeübertragungselement arbeitet, kann das Befestigungselement nur hinsichtlich der mechanischen Stabilität ausgebildet werden, ohne besondere wärmeübertragende Fähigkeiten aufweisen zu müssen. Die Befestigungseinrichtung ist dafür vorgesehen, eine Schaltung, insbesondere eine Leiterplatte, im Innenraum des Schaltungsgehäuses in wärmeleitendem Kontakt mit der Gehäusewand zu befestigen, wobei durch diese Befestigung gleichzeitig mindestens ein Bauteil in dem Innenraum des Schaltungsgehäuses befestigt wird, da das Bauteil auf der Leiterplatte befestigt ist, wobei die Schaltung im Wesentlichen das Bauteil und die Leiterplatte umfasst. Anstatt eines Schaltungsaufbaus mit Leiterplatten und darauf befestigten Bauteilen können prinzipiell auch vergossene Module (mit Wärmeabgabefläche) verwendet werden, die in dem Innenraum des Gehäuses befestigt sind und beim Schließen des Gehäuses mit der Gehäusewand in wärmeübertragenden Kontakt gebracht werden.

Vorzugsweise wird die Erfindung für Schaltungsgehäuse verwendet, die ein Innenraum vorsehen, der vollständig von der Umgebung des Schaltungsgehäuses abgetrennt ist. Eine derartige Kapselung ist abhängig von den Umgebungsbedingungen notwendig, beispielsweise bei der Verwendung des Schaltungsgehäuses im Motorraum eines Kraftfahrzeugs. Es ist ersichtlich, dass eine derartige vollständige Trennung notwendig ist, wenn die Umgebungsbedingungen den Betrieb der Schaltung beeinträchtigen können. Die Erfindung ermöglicht eine hervorragende Wärmeableitung trotz der vollständigen Kapselung der Schaltung. Das Schaltungsgehäuse umfasst somit vorzugsweise Verschlusselemente, die den Innenraum vollständig abdichten, wobei derartige Verschlusselemente auch Druckausgleichelemente wie Ventile umfassen können, oder verschließbare Öffnungen. Ferner kann das Schaltungsgehäuse abgedichtete elektrische Verbindungselemente umfassen, beispielsweise eine Steckerleiste oder eine SMD-Messerleiste, die mit einer Dichtung versehen ist, die die Kontaktelemente mit dem Gehäuse dichtend abschließt. Eine derartige Feststoffdichtung kann an den Verbindungselementen vorgesehen sein, beispielsweise an einer Messerleiste, und kann durch Anspritzen an die elektrischen Kontaktelemente vorgesehen werden. Das Gehäuse kann einteilig oder mehrteilig vorgesehen sein, beispielsweise in Form von zwei Gehäusehälften und kann ein oder mehrere Dichtungen umfassen. Die Dichtung kann beispielsweise in Form einer nass vernetzten Kleberaupe vorgesehen sein. Ferner kann das Gehäuse als Einschubgehäuse vorgesehen sein, in das die Schaltung eingeschoben wird. Das Schaltungsgehäuse kann eine Abdichtung umfassen, die eine Feststoffdichtung, beispielsweise als Radialdichtung ausgeführt, umfasst. Die Verschlusselemente können als Steckerleiste, vorzugsweise als Steckerleiste mit Dichtungsrand, vorgesehen sein, die das Gehäuse stirnseitig abschließen.

Je nach Gehäuseart kann es auch vorteilhaft sein, anstatt eines leichten Anpressdrucks zwischen Bauelement und Gehäusewand ein Spalt zwischen Gehäusewand und Bauelement (d.h. Wärmeabgabefläche) vorzusehen, wobei der Spalt durch eine Wärmeleitpaste, durch ein Alublech, das beispielsweise an das Bauteil oder an die Gehäusewand aufgeklebt wird, oder durch beides überbrückt wird. Abhängig von dem Material und der Wanddicke des Schaltungsgehäuses kann ein derartiges Blech auch zur Wärmeaufspreizung verwendet werden, um die Wärme des Bauteils besser aufzunehmen und an die Gehäusewand großflächig abgeben zu können.

Auf einer Außenseite des Schaltungsgehäuses, das der Innenfläche der Gehäusewand entgegengesetzt ist, können Kühlkörper vorgesehen sein, beispielsweise einteilig mit der Gehäusewand ausgeführt oder auf dieser befestigt. Vorzugsweise liegen derartige Kühlkörper dem Bauteil gegenüber. Durch diese zusätzlichen Kühlkörper wird die Wärmeabfuhr weitgehend verbessert. Das Gehäuse ist vorzugsweise aus einem gut wärmeleitenden Material ausgebildet, beispielsweise als Fließpressteil oder Tiefziehteil, beispielsweise aus Metall oder Kunststoff, vorzugsweise aus Aluminium oder einem wärmeleitenden Verbundwerkstoff. Insbesondere ist kann das Gehäuse auch durch Thixoforming (Thixomolding) ausgebildet werden, wobei ein Metall oder eine Legierung wird bis zur Übergangstemperatur zwischen fest und flüssig erhitzt wird. Dieser Zustand wird als thixotroper Zustand bezeichnet, in dem eine Mikrostruktur vorliegt, in der feinverteilte, kristallisierte Bestandteile in zusammenhängende Schmelzbereiche eingebettet sind. Die Ausformung kann durch ein Spritzgussverfahren vorgesehen werden, das Material im thixotropen Zustand verarbeitet.

Falls das Gehäuse mehrteilig ausgebildet ist, können die einzelnen Gehäuseteile auch durch Rastelemente miteinander verbunden werden, oder Verschlusselemente können durch Rastverbindungen mit dem Schaltungsgehäuse verbunden werden. Wie bereits bemerkt, kann das Verschlusselement auch elektrische Verbindungseigenschaften aufweisen, beispielsweise in der Form eines Steckverbinders, beispielsweise eine SMD-Messerleiste, die auf die Schaltung aufgelötet ist, oder durch Einzelpins, die auf die Schaltung aufgepresst und verlötet werden.

Ferner können Druckausgleichelemente in den Elementen vorgesehen sein, die auch den elektrischen Kontakt vorsehen, d.h. beispielsweise in einer Messerleiste. Dadurch wird die Anzahl der Fertigungselemente verringert. Die Druckausgleichelemente sind in der Gehäuse wand vorgesehen und verbinden zum Druckausgleich bei Überdruck den Gehäuseinnenraum mit der Umgebung. Die Druckausgleichelemente können auch zwischen Elementen vorgesehen sein, die auch den elektrischen Kontakt vorsehen

Die Schaltung kann einen Steuerteil und einen Hochleistungsteil aufweisen, wobei der Hochleistungsteil zu kühlende Elemente aufweist und der Steuerteil keine zu kühlenden Elemente aufweist. In diesem Fall sind die Hochleistungselemente vorzugsweise zusammen gruppiert und das Schaltungsgehäuse weist nur dort Wärmekopplungselemente auf, an denen die Hochleistungsbauelemente vorgesehen sind.

Vorzugsweise wird das erfindungsgemäße Schaltungsgehäuse zur Verkapselung von Leistungsmodulen in Kraftfahrzeugen verwendet, beispielsweise in Steuerelementen für Hybridantriebe, Ladeüberwachungssteuerungen, insbesondere für Traktionsbatterien von Hybridantrieben, Komponenten innerhalb des Antriebsstrangs von Hybrid- oder Elektrofahrzeugen und Ähnlichem. Die Erfindung erlaubt insbesondere bei diesen Anwendungen eine gute Verkapselung von Leistungsbauelementen bei geringem Platzbedarf, die einen hohen Betrag an Verlustwärme erzeugen. Insbesondere ist das erfindungsgemäße Schaltungsgehäuse geeignet, in elektronischen Steuereinheiten (ECU, electronic control unit) im Bereich Powertrain von Hybridantrieben eingesetzt zu werden.

Die Erfindung wird ferner von einem Verfahren umgesetzt, bei dem eine Schaltung und ein erfindungsgemäßes Schaltungsgehäuse vorgesehen wird. Das Verfahren umfasst den Schritt des Einfügens der Schaltung in das Gehäuse, wobei durch die erfindungsgemäße Ausprägung der Schaltung bzw. des Schaltungsgehäuses durch das mechanische Einbringen der Schaltung auch der unmittelbare wärmeübertragende Kontakt zwischen Bauelementen der Schaltung und Gehäusewand vorgesehen werden. Daher wird durch das Befestigen der Schaltung gleichzeitig eine unmittelbare physische Verbindung zwischen mindestens einem Bauelement und dem Schaltungsgehäuse bzw. der Gehäusewand des Schaltungsgehäuses hergestellt. Die unmittelbare physische Verbindung erzeugt die erfindungsgemäße Wärmekopplung zwischen Bauelement und Innenfläche der Gehäusewand. Dadurch, dass die wärmeleitende Verbindung gleichzeitig mit der Befestigung der Schaltung vorgesehen wird, wird ein grundlegender Herstellungsschritt eingespart, nämlich das Befestigen von Wärmeableitungselementen wie Kühlkörpern.

Das Befestigen der Schaltung im Gehäuse kann vorgesehen werden durch Einschieben oder durch Einbringen der Schaltung und darauf folgendem Verschließen des Gehäuses durch eine Schraubverbindung oder eine Schnappverbindung oder durch Verprägen eines Teils der Schaltung innerhalb des Gehäuses durch Verformen eines Teils der Gehäusewand. Ferner können elektrische Kontakte vorgesehen werden, indem diese an die Schaltung angelötet werden oder in diese eingesteckt werden und durch einen Fügeschritt das Schaltungsgehäuse durch die elektrischen Kontaktelemente verschlossen wird, insbesondere durch eine Dichtung, die mit den Kontaktelementen verbunden ist. Vor dem Einfügen der Schaltung in das Gehäuse können, falls vorgesehen, Wärmekopplungselemente an der Gehäusewand angebracht werden, beispielsweise Bleche, beispielsweise Alubleche, Wärmeleitpaste, oder beides. Vorzugsweise werden diese separaten Wärmekopplungselemente an den Stellen vorgesehen, die später im montierten Zustand den jeweiligen Stellen der Bauelemente und deren Wärmeabgabeflächen entsprechen.

### Kurze Beschreibung der Zeichnungen

Ausführungsbeispiele der Erfindung sind in den Zeichnungen dargestellt und in der nachfolgenden Beschreibung näher erläutert.

Es zeigen
- Figur 1: eine Explosionsdarstellung eines erfindungsgemäßen Schaltungsgehäuses und
- Figur 2: einen Querschnitt eines erfindungsgemäßen Schaltungsgehäuses.

### Ausführungsformen der Erfindung

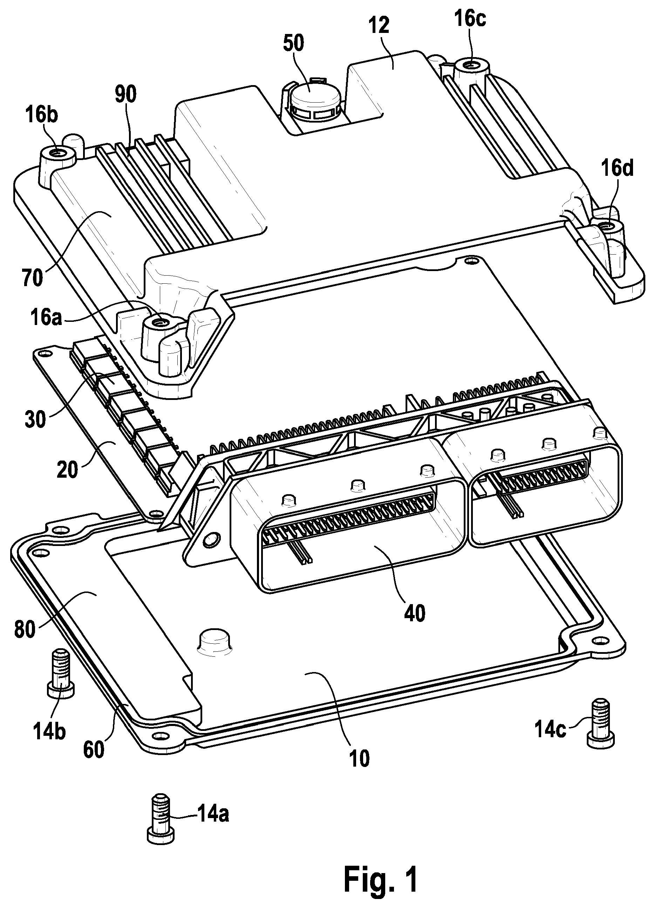

In der Figur 1 ist ein erfindungsgemäßes Schaltungsgehäuse dargestellt, das im Wesentlichen aus zwei Elementen besteht. Die zwei Elemente, die das Schaltungsgehäuse umfasst, sind eine Grundplatte 10 und ein Gussdeckel 12, vorzugsweise ein Deckel aus Metall, beispielsweise aus Aluminium. Der Gussdeckel wird über Schraubverbindungen 14a, b, c mit der Grundplatte verbunden, wobei die Grundplatte hierzu Durchstecklöcher umfasst, durch die die Schrauben durchgeführt werden, und der Gussdeckel Mutterelemente 16a, b, c, d umfasst, in die die Schrauben eingreifen. Die Grundplatte sowie der Gussdeckel sind geprägt und bilden somit einen Innenraum aus, in dem eine Schaltung 20 vorgesehen ist. Die Schaltung 20 umfasst im vorgesehenen Beispiel eine Leiterplatte (mit entsprechenden Durchgangslöchern für die Steckverbindung), Bauelemente 30, die als Leistungsbauelemente vorgesehen sind und Wärme abgeben, sowie weitere Bauelemente (nicht dargestellt), die nicht gekühlt werden müssen, beispielsweise Prozessoren, Logik- oder Steuerschaltkreise und Ähnliches.

Die Schaltung umfasst ferner eine elektrische Schnittstelle 40, die als Steckerleiste mit zugehörigen Auskragungen zur Abdichtung ausgestaltet ist. Beim Verbinden des Gussdeckels mit der Grundplatte dichtet die Auskragung der Steckerleiste den Innenraum ab. Der Gussdeckel umfasst ferner ein Druckausgleichselement 50, das den Innenraum des Schaltungsgehäuses nur zum Druckausgleich mit dem Außenraum verbindet. Ansonsten sind weitere Dichtungen 60 vorgesehen, die den Gussdeckel mit der Grundplatte abdichten.

Der Gussdeckel umfasst Wärmekopplungselemente 70 in Form einer geprägten, nach außen gerichteten Vertiefung, in der die Leistungsbauteile 30 angeordnet sind, wobei die Bauelemente eine von der Leiterplatte abgewandte Oberfläche aufweisen, die nach der Montage des Schaltungsgehäuses einen unmittelbaren Kontakt mit den Wärmekopplungselementen 70 vorsehen. Die in Figur 1 dargestellte Ausführung umfasst besonders einfach ausgebildete Wärmekopplungselemente in Form einer durchgehenden horizontalen Innenfläche eines Abschnitts der Innenseite des Gussdeckels, wobei der Gussdeckel die Gehäusewand vorsieht. Als Befestigungseinrichtung sind entsprechende Verprägungen des Gussdeckels und der Grundplatte vorgesehen, die nach Montage die Leiterplatte der Schaltung 20 fixieren. Als Befestigungselemente der Schaltung 30 dienen somit die erhabenen Randelemente 80 der Grundplatte, sowie die entsprechenden Gegenstücke des Gussdeckels.

Der Gussdeckel umfasst ferner Kühlrippen 90, die in der Nähe der Wärmekopplungselemente vorgesehen sind und nach außen ragen.

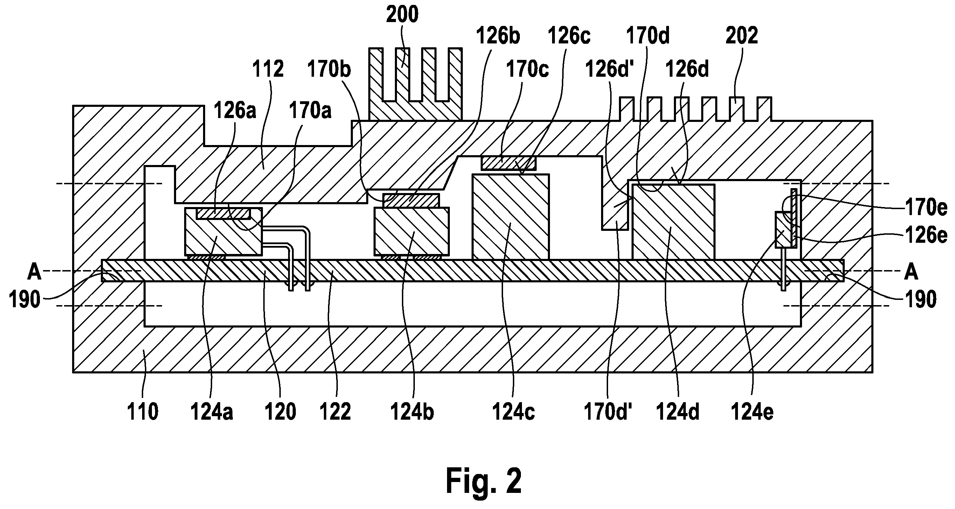

Die Figur 2 zeigt ein erfindungsgemäßes Schaltungsgehäuse 110 in der Schnittdarstellung. Das Schaltungsgehäuse bildet einen Innenraum aus, in dem eine Schaltung 120 vorgesehen ist. Die Schaltung 120 umfasst eine Leiterplatte 122 als Träger für verschiedene Bauelemente 124a, b, c, d, e. Die Bauteile 124a und b weisen SMD-Lötverbindungen mit einer Oberfläche der Leiterplatte 120 auf, wobei die Bauelemente 124a und 124e über Verbindungen in Durchstecktechnik mit der Leiterplatte 120 verbunden sind. Die Lötkontakte der Durchsteckverbindungen sind auf einer Unterseite der Leiterplatte, wohingegen die SMD-Lötverbindungen auf einer Oberseite der Leiterplatte 120 vorgesehen sind. Anstatt SMD-Lötverbindungen oder in Kombination hiermit können die Bauelemente auch mittels Durchstecktechnik mit der Leiterplatte verbunden werden. Die Bauelemente 124a, b, c und d umfassen eine Wärmeabgabefläche 126a, b, c und d, die von der Leiterplatte 120 weg gewandt ist und zur Gehäusewand 112 hin gewandt ist. Die Wärmeabgabefläche 126a des Bauelements 124a schließt mit einer Oberseite des Bauelements 124 ab, wie es von Bauelemente in *slug up*-Technik bekannt ist. Die Wärmeabgabefläche 126b ist auf einer Oberfläche des Bauteils 124b vorgesehen und kann beispielsweise mit dem Bauelement 124b verklebt oder verlötet sein.

Die Wärmeabgabefläche 126c des Bauelements 124c weist im Gegensatz zu den Bauelementen 124a und 124b kein eigens ausgestaltetes separates Kontaktelement auf, das eine Wärmeabgabefläche vorsieht. Derartige Kontaktelemente 126a, b können beispielsweise durch Stahl-, Aluminium- oder Kupferbleche vorgesehen werden, die einen Leistungshalbleiter tragen, vorzugsweise werden die Leistungshalbleiter jedoch durch Bestückung (Löten) auf der Leiterplatte befestigt. Der Wärmeabgabefläche 126c gegenüber ist ein Wärmekopplungselement 170 vorgesehen, das auf der Gehäusewand befestigt ist, und eine Wärmekopplungsfläche vorsieht, die der Wärmeabgabefläche 126c direkt gegenüberliegt. Die so vorgesehenen Abschnitte 170a, b der Innenfläche der Gehäusewand bilden somit Wärmekopplungselemente. Das Wärmekopplungselement 170c kann mittels Klebung oder anderen Formen bzw. kraftschlüssigen Verbindungen mit der Gehäusewand verbunden sein oder kann einteilig mit dieser ausgebildet sein. Die Wärmeabgabefläche 126d des Bauelements 124d ist wie die Bauelemente 124a, b über ein Wärmekopplungselement 170d mit der Gehäusewand verbunden, das durch einen Abschnitt der Innenfläche der Gehäusewand vorgesehen wird.

Während die Abgabeflächen 126a-d und die zugehörigen Wärmekopplungselemente 170a-d horizontal und somit parallel zur Leiterplatte 120 ausgebildet sind, erstreckt sich eine weitere Wärmeabgabefläche 126d' gewinkelt zur Leiterplatte, im in Figur 2 dargestellten Fall senkrecht (im Allgemeinen geneigt) zur Leiterplatte. Gegenüber der senkrechten (im Allgemeinen geneigten) Wärmeabgabefläche 126d' ist ein entsprechendes Wärmekopplungselement 170d' vorgesehen, das sich von der Gehäusewand zur Leiterplatte 120 hin erstreckt und an der zur Wärmeabgabefläche 126d' hin gewandten Seite einen Flächenabschnitt aufweist, der wärmeleitend mit der Wärmeabgabefläche 126d' verbunden ist. In gleicher Weise weist das Bauelement 124e eine Wärmeabgabefläche 126e auf, das einem zugeordneten Wärmekopplungselement 170e gegenüberliegt. Das entsprechende Wärmekopplungselement ist, wie auch die Wärmekopplungselemente 170a, b, d und d', durch einen Teil der Innenfläche der Gehäusewand vorgesehen, wobei jedoch der entsprechende Abschnitt der Gehäusewandinnenfläche senkrecht (im Allgemeinen geneigt) zur Leiterplatte verläuft.

Die Lücke zwischen den Wärmekopplungselementen 170a-e und den zugehörigen Wärmeabgabeflächen 126a-e ist zur besseren Darstellung eingezeichnet und kann beispielsweise einem direkten, unmittelbaren Kontakt entsprechen, so dass die Lücke eine Breite von Null aufweist. In diesem Fall sind die jeweiligen Wärmekopplungselemente vorzugsweise direkt auf die entsprechenden Wärmeabgabeflächen aufgedrückt. In gleicher Weise kann die Lücke mit einem Kopplungselement gefüllt sein, beispielsweise einer Wärmeleitpaste, wärmeleitenden Folie oder wärmeleitenden Schicht, beispielsweise Glimmer. Das in Figur 2 mit dem Bezugszeichen 170c vorgesehene Wärmekopplungselement kann als ein derartiges Kopplungselement interpretiert werden, das den Abstand zwischen Gehäusewandinnenfläche und Wärmeabgabefläche verringert bzw. aufhebt und somit den Kontakt zum Bauelement 124c herstellt.

Das in Figur 2 dargestellte Gehäuse umgibt die Schaltung 120 vollständig. In diesem Fall wird die Leiterplatte in einer Richtung in das Schaltungsgehäuse 110 eingeschoben, die in die Zeichenebene hineinzeigt. Alternativ kann an den mit gestrichelten Linien dargestellten Stellen eine körperliche Trennung zwischen zwei Schaltungsgehäusehälften vorgesehen sein, die durch Zusammenfügen das Schaltungsgehäuse bilden. Die Schaltungsgehäusehälften können durch eine äußere Klammer, durch Schraubverbindungen, durch Schnappverbindungen, durch formschlüssige oder kraftschlüssige Verbindungen miteinander mechanisch verbunden werden.

Das in Figur 2 dargestellte Schaltungsgehäuse umfasst eine Befestigungseinrichtung 190 in Form einer Nut, die senkrecht zur Zeichenebene verläuft. In diese Nut wird die Schaltung entweder in eine Richtung eingeschoben, die senkrecht zur Zeichenebene ist (für den Fall, dass das Schaltungsgehäuse einteilig vorgesehen ist), oder wird in die Nut 190 eingelegt, wenn das Schaltungsgehäuse zweiteilig ist und die Trennung zweier Schaltungsgehäusehälften an der Stelle A verläuft, in der auch die Leiterplatte der Schaltung 120 vorgesehen ist. Das Schaltungsgehäuse kann ferner Kühlkörper 200, 202 aufweisen, die mit der Gehäusewand einteilig ausgebildet sind, vgl. Bezugszeichen 202, oder die auf der Gehäusewand befestigt sind, vgl. Bezugszeichen 200. Die Befestigung umfasst vorzugsweise eine wärmeleitende Kopplung. Die Kühlelemente sind auf einer Außenfläche der Gehäusewand angeordnet, die entgegengesetzt zum Innenraum liegt. Vorzugsweise sind die Kühlkörper 200 und 202 gegenüberliegend zu den Wärmekopplungselementen angeordnet, die mit Bauelementen wärmeübertragend verbunden sind, die in besonders starkem Maße Wärme abgeben. Dies ist beispielsweise in Figur 2 für die Bauteile 124b und 124d der Fall. Das Wärmekopplungselement 170a ist durch eine zum Innenraum hin gerichtete Vertiefung des Schaltungsgehäuses vorgesehen, um den Abstand zwischen Wärmekopplungselement 170a und Wärmeabgabefläche 126a so gering wie möglich zu halten bzw. auf Null zu reduzieren. Eine derartige Formung des Schaltungsgehäuses kann vorgesehen werden, indem das Schaltungsgehäuse als Fließpressteil oder als Tiefziehteil ausgebildet ist. Die Vertiefung entspricht dann den entsprechenden Formen des formgebenden Werkzeugs. Im Falle eines zweiteiligen oder mehrteiligen Schaltungsgehäuses werden diese vorzugsweise durch Dichtungen miteinander abgedichtet, wobei die Figur 2 keine Dichtung darstellt. Dennoch ist in der in Figur 2 dargestellten Ausführung eine Dichtung dort möglich, wo die gestrichelten Linien eine Trennung zwischen den zwei Schaltungsgehäusehälften vorsehen.

In einer weiteren Ausführungsform der Erfindung, die auf der in Figur 2 dargestellten Ausführungsform basiert, weist der Gehäuseabschnitt, der dem Gehäusewand entgegengesetzt ist, d.h. der untere Gehäuseabschnitt, der abgewandt von den Wärmekopplungselementen vorgesehen ist, Ausbildungen für Stecker auf. Der untere Gehäuseabschnitt umfasst somit Stecker-Kontaktelemente, die sich vom Gehäuseinneren nach außen von der Leiterplatte weg erstrecken. Die Stecker-Kontaktelemente erstrecken sich somit in eine Richtung, die von der oberen Gehäusehälfte (und von den Bauelementen) weg weist. Die Stecker-Kontaktelemente sind beispielsweise als Messerleisten oder als SMD-Messerleisten ausgebildet, die vorzugsweise zumindest teilweise in einer oder in mehreren Steckerkammern vorgesehen sind, die von dem unteren Gehäuseabschnitt ausgebildet werden. Vorzugsweise befinden sich alle aus dem Gehäuse hinausragenden Stecker-Kontaktelemente in einer oder in mehreren Steckerkammern, die einteilig mit dem unteren Gehäuseabschnitt ausgebildet sind, oder die an diesem befestigt sind. Die Steckerkammern sind senkrecht zur Leiterplatte ausgerichtet und nach außen hin geöffnet. Die Stecker-Kontaktelemente sind ferner vorzugsweise mit der Leiterplatte im Gehäuseinneren verbunden. Die Stecker-Kontaktelemente erstrecken sich im wesentlichen senkrecht zur Leiterplatte, abgesehen von einem direkt an der Leiterplatte vorgesehen Kontaktabschnitt, in dem die Kontaktelemente dem Verlauf der Leiterplatte folgen, dazwischen befindet sich eine Biegestelle, in der das der Leiterplatte folgende Stück der Kontaktelemente in eine Richtung senkrecht zur Leiterplatte übergeht. Alternativ erstrecken sich die Kontaktelemente vollständig entlang der Leiterplatte, wobei die Steckerkammern entsprechend entlang der Leiterplatte ausgerichtet sind. Der unteren Gehäuseabschnitt umfasst ferner vorzugsweise ein Druckausgleichselement, das bei Überdruck das Gehäuseinnere mit der Umgebung zum Druckausgleich verbindet und ansonsten das Gehäuseinnere abschließt. Das Druckausgleichselement ist beispielsweise an einer Steckerkammer oder zwischen zwei Steckerkammern vorgesehen. Alternativ kann ein Druckausgleichselement in dem oberen Gehäuseabschnitt vorgesehen sein, d.h. auf der Bestückungsseite der Leiterplatte. Der untere Gehäuseabschnitt umfasst ferner Verbindungselemente, die mit Verbindungselementen des oberen Gehäuseabschnitts verbindbar sind. Die Verbindungselemente des oberen und des unteren Gehäuseabschnitts können als komplementäre Schnappverbindungselemente ausgebildet sein, die eine abdichtende Verbindung für das Gehäuse vorsehen. Hierdurch kann die Bauform, insbesondere Höhe und Länge des Gehäuses incl. elektrischer Verbindung, die von den Kontaktelementen vorgesehen wird, besonders kompakt vorgesehen werden. Innerhalb des Gehäuses kann ein Raum für Sonderbauelemente vorgesehen sein, die über die Wärmekopplungselemente gekühlt werden oder nicht gekühlt werden, beispielsweise Elektrolytkondensatoren oder andere Bauelemente mit einem gewissen Raumbedarf, die an der Leiterplatte befestigt sind. Ein Druckausgleichselement kann an einer Gehäusewand an einem der Sonderbauelemente angeordnet sein, insbesondere an einem nicht zu kühlenden Sonderbauelement.

Die so beschriebene zweiteilige Bauform des Gehäuses kann durch einen Herstellungsprozess vorgesehen werden, der die folgenden Schritte umfasst: (a) Anordnen und Befestigen von Steckerpins (= Stecker-Kontaktelemente) auf der Leiterplatte, (b) Anordnen und Befestigen von Bauelementen auf der Leiterplatte. Schritte (a) und (b) sind in beliebiger Reihenfolge und auch gleichzeitig ausführbar. Schritt (c): Löten der Bauelemente und der Steckerpins; Schritt (d): Umspritzen der Steckerpins; Schritt (e) Anbringen des oberen Gehäuseabschnitts an den unteren Gehäuseabschnitt, wobei Verbindungselemente ausgestaltet sind, um als Fügehilfe zu dienen. Die Verbindungselemente können ferner mit einer angespritzten Dichtung vorgesehen werden, um das Gehäuseinnere abzuschließen.

In einer weiteren Ausführungsform wird eine Leiterplatte von einem nach oben (zur Bauelementeseite hin) offenen Gehäuseabschnitt gehalten und ist mit dem Gehäuseabschnitt abgedichtet. Ein Kühlabschnitt des Gehäuses wird zum Abschluss des Raums, der vom offenen Gehäuseabschnitt und der Leiterplatte gebildet wird, auf den offenen Gehäuseabschnitt aufgesetzt und mittels Verbindungselemente mit diesem Verbunden. Als Verbindungselemente dienen Schnappverschluss- oder Einrastelemente. Ferner kann zusätzlich die Verbindung von Gehäuseabschnitt und Kühlabschnitt mit einer angespritzten Dichtung abgedichtet werden. Der offenen Gehäuseabschnitt erstreckt auch in die von dem Kühlabschnitt abgewandten Richtung und bildet dort vorzugsweise eine oder mehrere Steckerkammern. Stecker-Kontaktelemente sind in den Steckerkammern vorgesehen, erstrecken sind senkrecht zur Leiterplatte, und sind mit der Leiterplatte elektrisch verbunden. Der offenen Gehäuseabschnitt kann in zylindrischer Form ausgebildet sein, der Kühlabschnitt bildet dann den stirnseitigen Deckel des Gehäuses, wobei der offenen Gehäuseabschnitt Befestigungselemente mit einem Anschlag sowie Befestigungselemente für die Anordnung der Leiterplatte umfasst. Beim Befestigen des Kühlabschnitts dient der Anschlag und dessen im wesentlichen starre Anordnung zu den Befestigungselementen für die Anordnung der Leiterplatte dazu, dass Bauelemente auf der Kühlabschnittseite der Leiterplatte in unmittelbaren Kontakt mit dem Kühlabschnitt kommen. Beim Schließen des Gehäuses wird somit gleichzeitig die Wärme übertragende Verbindung zwischen Bauelement und Kühlabschnitt und der Abschluss des Gehäuseinneren vorgesehen. Das Schaltungsgehäuse umfasst somit Kühlabschnitt und einen offenen Gehäuseabschnitt, der Befestigungen für die Leiterplatte und für den Kühlabschnitt vorsieht. Eine oder mehrere Steckerkammern sind vorzugsweise einteilig mit dem offenen Gehäuseabschnitt ausgebildet, wobei die Steckerkammern durch die Leiterplatte von dem Raum getrennt sind, der zwischen Leiterplatte und Kühlabschnitt vorgesehen ist. Der Kühlabschnitt kann als Platte mit senkrecht dazu verlaufenden Außenrändern ausgebildet sein, wobei die Außenränder direkt mit einer Innenseite des offenen Gehäuseabschnitts verbunden sind und sich entlang dieser erstrecken. Die Anordnung der Außenränder und somit des Kühlabschnitts zu der Leiterplatte wird durch eine steife Verbindung zwischen Befestigungselementen (bsp. mit Anschlag oder Auflager) für die Außenränder und Befestigungselementen für die Leiterplatte (bsp. ebenso mit Anschlag oder Auflager) vorgesehen.

Aspekte der Erfindung umfassen die Ausbildung des Schaltungsgehäuses in Form von Schalenkonzept mit zwei Gehäusehälften, eine Verbindung der Gehäuseteile mittels Schrauben; eine Abdichtung in Form einer nassvernetzenden Kleberaupe und zusätzliche Wärmeableitung der Leistungsbauelemente durch die Leiterplatte (beispielsweise mittels verkupferter Bohrungen) sowie eine Wärmeleitpaste zur Spaltüberbrückung zwischen Leiterplattenunterseite und Gehäuse, die einen zumindest Teil des Wärmekopplungselements ausbildet.

Weitere Aspekte der Erfindung umfassen ein Einschubgehäuse bestehend aus einem Gehäuseteil, in das die bestückte Leiterplatte eingeschoben wird, wobei Führungselemente des Gehäuses zur Anordnung der Leiterplatte die Platzierung der Bauteile in unmittelbarem Kontakt mit einem Wärmekopplungselement (ein Innenflächenabschnitt des Gehäuses, gegebenenfalls einschließlich einer Wärmepastenschicht) angeordnet und ausgestaltet sind. Ferner wird das Gehäuse gemäß diesem Aspekt der Erfindung stirnseitig durch die Steckerleiste verschlossen. Das Gehäuse wird Abgedichtet mittels einer Feststoffdichtung vorzugsweise als Radialdichtung. Die Wärmeableitung wird wie bereits anhand andere Aspekte beschrieben vorgesehen. Anstatt einer Wärmeleitpaste oder in Kombination hiermit wird jedoch ein Alu-Blech zur Wärmeaufspreizung und Ableitung an das Gehäuse auf die Leiterplatte geklebt.

Gemäß des der Erfindung zugrunde liegenden Konzepts ist das Entwärmungskonzept für das Gehäuse, demgemäß dass die Wärme nicht mehr durch die Leiterplatte abgeleitet wird, wie es aus dem Stand der Technik bekannt ist, sondern direkt in das Gehäuse abgeleitet wird und das Gehäuse als Wärmesenke in direktem Kontakt mit Wärmeabgabeflächen der Bauelemente steht.

## Patentansprüche

1. Schaltungsgehäuse (10; 110) mit einem Wärmekopplungselement und einer Befestigungseinrichtung (80; 180) zur Befestigung einer Schaltung (20; 120) mit mindestens einem Bauteil im Innenraum des Schaltungsgehäuses (10; 110), wobei eine Gehäusewand des Schaltungsgehäuses (10; 110) das Wärmekopplungselement (70; 170) umfasst, das Wärmekopplungselement (70; 170) an einer Innenfläche (170a, d, e) der Gehäusewand angeordnet ist, und die Befestigungseinrichtung (80; 180) eingerichtet ist, das mindestens eine Bauteil (30, 124) im Innenraum des Schaltungsgehäuses (10; 110) und in unmittelbarem Kontakt mit dem Wärmekopplungselement (70; 170) zu platzieren, **dadurch gekennzeichnet, dass** sich eine Wärmeabgabefläche (126d') des mindestens einen Bauteils (124d) geneigt zur Schaltung (120) erstreckt und gegenüber der geneigten Wärmeabgabefläche (126d') das Wärmekopplungselement (170d') entsprechend vorgesehen ist, das sich von der Gehäusewand zur Schaltung (120) hin erstreckt und an der zur Wärmeabgabefläche (126d') hin gewandten Seite einen Flächenabschnitt aufweist, der wärmeleitend mit der Wärmeabgabefläche (126d') verbunden ist.

2. Schaltungsgehäuse (10; 110) nach Anspruch 1, wobei das Wärmekopplungselement (70; 170) mit der Gehäusewand wärmeleitend verbunden ist und eine Wärmekopplungsfläche vorsieht, die eingerichtet ist, unmittelbar oder über Wärmekopplungselemente (170b,c) auf einer Wärmeabgabefläche des mindestens einen Bauteils (30, 124) der im Innenraum befestigbaren Schaltung (20; 120) angeordnet zu sein, wenn die Schaltung (20; 120) im Innenraum befestigt ist.

3. Schaltungsgehäuse (10; 110) nach einem der vorangehenden Ansprüche, wobei das Wärmekopplungselement (70; 170) einen Abschnitt der Innenfläche umfasst, der sich in einer Ebene (A) erstreckt, wobei, wenn die Schaltung (20; 120) in dem Schaltungsgehäuse (10; 110) befestigt ist, das mindestens eine Bauteil (30, 124) eine sich entlang dieser Ebene (A) erstreckende Oberfläche umfasst, und die Oberfläche des Bauteils (30, 124) zusammen mit dem Abschnitt der Innenfläche eine unmittelbare oder über Kontaktelemente vorgesehene wärmeleitende Verbindung vorsehen.

4. Schaltungsgehäuse (10; 110) nach einem der vorangehenden Ansprüche, wobei das Wärmekopplungselement (70; 170) einen in den Innenraum ragenden Abschnitt (112, 170d') der Innenfläche der Gehäusewand umfasst und einteilig mit der Gehäusewand ausgebildet ist.

5. Schaltungsgehäuse (10; 110) nach einem der vorangehenden Ansprüche, wobei das Wärmekopplungselement (70; 170) elektrisch isolierend ist, Wärmeleitpaste, wärmeleitende Folie oder eine wärmeleitende Schicht umfasst, und die Wärmeleitpaste, wärmeleitende Folie oder wärmeleitende Schicht zwischen der Gehäusewand und dem mindestens einen Bauteil (30, 124) angeordnet ist und an die Gehäusewand sowie an das mindestens eine Bauteil (30, 124) angrenzt.

6. Schaltungsgehäuse (10; 110) nach einem der vorangehenden Ansprüche, wobei die Schaltung (20; 120) in dem Schaltungsgehäuse (10; 110) angeordnet ist und das mindestens eine Bauteil (30, 124) mindestens ein Leistungsbauteil umfasst, das eine Wärmeabgabefläche aufweist, die zu der Gehäusewand hin gewandt ist, und die in unmittelbarem wärmeleitendem Kontakt mit dem Wärmekopplungselement (70; 170) steht.

7. Schaltungsgehäuse (10; 110) nach einem der vorangehenden Ansprüche, wobei die Befestigungseinrichtung (80; 180) Träger, Führungselemente, Führungsschienen oder Führungsnuten umfasst, die im Innenraum des Schaltungsgehäuses (10; 110) ausgebildet sind, und die eingerichtet sind, die Schaltung (20; 120) im Innenraum des Schaltungsgehäuses (10; 110) zu halten.

8. Schaltungsgehäuse (10; 110) nach einem der vorangehenden Ansprüche, wobei die Befestigungseinrichtung (80; 180) eingerichtet ist, eine Leiterplatte im Innenraum des Schaltungsgehäuses (10; 110) zu befestigen, die zusammen mit dem mindestens einen Bauteil (30, 124), das auf der Leiterplatte befestigt ist, die Schaltung (20; 120) vorsieht.

9. Schaltungsgehäuse (10; 110) nach einem der vorangehenden Ansprüche, das Verschlusselemente (40, 50, 60) aufweist, die den Innenraum des Schaltungsgehäuses (10; 110) vollständig von dem Raum außerhalb des Schaltungsgehäuses (10; 110) abtrennen.

10. Verfahren zur wärmeableitenden Befestigung einer Schaltung (20; 120) in einem Schaltungsgehäuse (10; 110) nach einem der vorangehenden Ansprüche, umfassend:
Vorsehen der Schaltung (20; 120);
Vorsehen des Schaltungsgehäuses(10; 110);
Einfügen der Schaltung in das Schaltungsgehäuse (10; 110), wobei der Schritt des Einfügens umfasst: Befestigen der Schaltung in dem Schaltungsgehäuse (10; 110), gleichzeitig mit dem Herstellen einer wärmeleitenden und unmittelbaren physischen Verbindung (126; 170) zwischen dem mindestens einen Bauelement (30, 124) und dem Schaltungsgehäuse (10; 110),
**dadurch gekennzeichnet, dass**
sich eine Wärmeabgabefläche (126d') des mindestens einen Bauteils (124d) geneigt zur Schaltung (120) erstreckt und gegenüber der geneigten Wärmeabgabefläche (126d') das Wärmekopplungselement (170d') entsprechend vorgesehen wird, das sich von der Gehäusewand zur Schaltung (120) hin erstreckt und an der zur Wärmeabgabefläche (126d') hin gewandten Seite einen Flächenabschnitt aufweist, der wärmeleitend mit der Wärmeabgabefläche (126d') verbunden ist.

## Claims

1. Circuit housing (10; 110) having a heat-coupling element and a fastening device (80; 180) for fastening a circuit (20, 120) to at least one component in the interior of the circuit housing (10; 110), wherein a housing wall of the circuit housing (10; 110) comprises the heat-coupling element (70; 170), the heat-coupling element (70; 170) is arranged on an inner surface (170a, d, e) of the housing wall, and the fastening device (80; 180) is designed to position the at least one component (30, 124) in the interior of the circuit housing (10; 110) and in direct contact with the heat-coupling element (70; 170), **characterized in that** a heat-emitting area (126d') of the at least one component (124d) extends in an inclined manner in relation to the circuit (120) and the heat-coupling element (170d') is accordingly provided opposite the inclined heat-emitting area (126d'), the said heat-coupling element extending from the housing wall in the direction of the circuit (120) and having a surface section, which is connected in a thermally conductive manner to the heat-emitting area (126d'), on that side which faces the heat-emitting area (126d').

2. Circuit housing (10; 110) according to Claim 1, wherein the heat-coupling element (70; 170) is connected in a thermally conductive manner to the housing wall and provides a heat-coupling area which is designed to be arranged, directly or via heat-coupling elements (170b, c), on a heat-emitting area of the at least one component (30, 124) of the circuit (20; 120), which can be fastened in the interior, when the circuit (20; 120) is fastened in the interior.

3. Circuit housing (10; 110) according to either of the preceding claims, wherein the heat-coupling element (70; 170) comprises a section of the inner surface, which section extends in a plane (A), wherein, when the circuit (20; 120) is fastened in the circuit housing (10; 110), the at least one component (30, 124) comprises a surface which extends along this plane (A), and the surface of the component (30, 124) together with the section of the inner surface provide a direct thermally conductive connection or a thermally conductive connection which is provided via contact elements.

4. Circuit housing (10; 110) according to one of the preceding claims, wherein the heat-coupling element (70; 170) comprises a section (112, 170d'), which projects into the interior, of the inner surface of the housing wall and is integrally formed with the housing wall.

5. Circuit housing (10; 110) according to one of the preceding claims, wherein the heat-coupling element (70; 170) is electrically insulating, comprises heat-conducting paste, thermally conductive foil or a thermally conductive layer, and the heat-conducting paste, thermally conductive foil or thermally conductive layer is arranged between the housing wall and the at least one component (30, 124) and adjoins the housing wall and the at least one component (30, 124).

6. Circuit housing (10; 110) according to one of the preceding claims, wherein the circuit (20; 120) is arranged in the circuit housing (10; 110), and the at least one component (30, 124) comprises at least one power component which has a heat-emitting area which faces the housing wall and which is in direct thermally conductive contact with the heat-coupling element (70; 170).

7. Circuit housing (10; 110) according to one of the preceding claims, wherein the fastening device (80; 180) comprises supports, guide elements, guide rails or guide grooves which are formed in the interior of the circuit housing (10; 110), and which are designed to hold the circuit (20; 120) in the interior of the circuit housing (10; 110).

8. Circuit housing (10; 110) according to one of the preceding claims, wherein the fastening device (80; 180) is designed to fasten a printed circuit board in the interior of the circuit housing (10; 110), the said printed circuit board, together with the at least one component (30, 124) which is fastened on the printed circuit board, providing the circuit (20, 120).

9. Circuit housing (10; 110) according to one of the preceding claims, which has closure elements (40, 50, 60) which completely separate the interior of the circuit housing (10; 110) from the area outside the circuit housing (10; 110).

10. Method for fastening a circuit (20; 120) in a heat-dissipating manner in a circuit housing (10; 110) according to one of the preceding claims, comprising:
providing the circuit (20; 120);
providing the circuit housing (10; 110);
inserting the circuit into the circuit housing (10; 110), wherein the insertion step comprises: fastening the circuit in the circuit housing (10; 110) at the same time as producing a thermally conductive and direct physical connection (126; 170) between the at least one component (30, 124) and the circuit housing (10; 110),
**characterized in that**
a heat-emitting area (126d') of the at least one component (124d) extends in an inclined manner in relation to the circuit (120) and the heat-coupling element (170d') is accordingly provided opposite the inclined heat-emitting area (126d'), the said heat-coupling element extending from the housing wall in the direction of the circuit (120) and having a surface section, which is connected in a thermally conductive manner to the heat-emitting area (126d'), on that side which faces the heat-emitting area (126d').

## Revendications

1. Boîtier de circuit (10 ; 110) comprenant un élément de couplage thermique et un dispositif de fixation (80 ; 180) pour la fixation d'un circuit (20 ; 120) avec au moins un composant dans un espace intérieur du boîtier de circuit (10 ; 110), une paroi de boîtier du boîtier de circuit (10 ; 110) comprenant l'élément de couplage thermique (70 ; 170), l'élément de couplage thermique (70 ; 170) étant disposé sur une surface intérieure (170a, d, e) de la paroi de boîtier et le dispositif de fixation (80 ; 180) étant prévu pour placer l'au moins un composant (30, 124) dans l'espace intérieur du boîtier de circuit (10 ; 110) et en contact direct avec l'élément de couplage thermique (70 ; 170), **caractérisé en ce qu'**une surface de diffusion thermique (126d') de l'au moins un composant (124d) s'étend de manière inclinée par rapport au circuit (120) et l'élément de couplage thermique (170d') étant prévu de manière correspondante en face de la surface de diffusion thermique inclinée (126d'), lequel s'étend depuis la paroi de boîtier vers le circuit (120) et présente, au niveau du côté tourné vers la surface de diffusion thermique (126d'), une section de surface qui est connectée de manière thermoconductrice à la surface de diffusion thermique (126d').

2. Boîtier de circuit (10 ; 110) selon la revendication 1, dans lequel l'élément de couplage thermique (70 ; 170) est connecté de manière thermoconductrice à la paroi de boîtier et présente une surface de couplage thermique qui est prévue pour être disposée directement ou par le biais d'éléments de couplage thermique (170b, c) sur une surface de diffusion thermique de l'au moins un composant (30, 124) du circuit (20 ; 120) pouvant être fixé dans l'espace intérieur, lorsque le circuit (20 ; 120) est fixé dans l'espace intérieur.

3. Boîtier de circuit (10 ; 110) selon l'une quelconque des revendications précédentes, dans lequel l'élément de couplage thermique (70 ; 170) comprend une section de la surface intérieure qui s'étend dans un plan (A), l'au moins un composant (30, 124), lorsque le circuit (20 ; 120) est fixé dans le boîtier de circuit (10 ; 110), comprenant une surface s'étendant le long de ce plan (A), et la surface du composant (30, 124) conjointement avec la section de la surface intérieure formant une connexion thermoconductrice directe ou fournie par le biais d'éléments de contact.

4. Boîtier de circuit (10 ; 110) selon l'une quelconque des revendications précédentes, dans lequel l'élément de couplage thermique (70 ; 170) comprend une section (112, 170d') de la surface intérieure de la paroi de boîtier qui fait saillie dans l'espace intérieur et qui est réalisée d'une seule pièce avec la paroi de boîtier.

5. Boîtier de circuit (10 ; 110) selon l'une quelconque des revendications précédentes, dans lequel l'élément de couplage thermique (70 ; 170) est électriquement isolant, comprend une pâte thermoconductrice, un film thermoconducteur ou une couche thermoconductrice, et la pâte thermoconductrice, le film thermoconducteur ou la couche thermoconductrice est disposé(e) entre la paroi de boîtier et l'au moins un composant (30, 124) et est adjacent(e) au boîtier ainsi qu'à l'au moins un composant (30, 124).

6. Boîtier de circuit (10 ; 110) selon l'une quelconque des revendications précédentes, dans lequel le circuit (20 ; 120) est disposé dans le boîtier de circuit (10 ; 110) et l'au moins un composant (30, 124) comprend au moins un composant de puissance qui présente une surface de diffusion thermique tournée vers la paroi de boîtier et qui est en contact thermoconducteur direct avec l'élément de couplage thermique (70 ; 170).

7. Boîtier de circuit (10 ; 110) selon l'une quelconque des revendications précédentes, dans lequel le dispositif de fixation (80 ; 180) comprend des supports, des éléments de guidage, des rails de guidage ou des rainures de guidage qui sont réalisés dans l'espace intérieur du boîtier de circuit (10 ; 110) et qui sont prévus pour retenir le circuit (20 ; 120) dans l'espace intérieur du boîtier de circuit (10 ; 110).

8. Boîtier de circuit (10 ; 110) selon l'une quelconque des revendications précédentes, dans lequel le dispositif de fixation (80 ; 180) est prévu pour fixer une carte à circuits imprimés dans l'espace intérieur du boîtier de circuit (10 ; 110), laquelle comprend le circuit (20 ; 120), conjointement avec l'au moins un composant (30, 124) fixé sur la carte à circuits imprimés.

9. Boîtier de circuit (10 ; 110) selon l'une quelconque des revendications précédentes, qui présente des éléments de fermeture (40, 50, 60) qui séparent l'espace intérieur du boîtier de circuit (10 ; 110) complètement de l'espace à l'extérieur du boîtier de circuit (10 ; 110).

10. Procédé de fixation avec dissipation de la chaleur d'un circuit (20 ; 120) dans un boîtier de circuit (10 ; 110) selon l'une quelconque des revendications précédentes, comprenant :
fournir le circuit (20 ; 120) ;
fournir le boîtier de circuit (10 ; 110) ;
introduire le circuit dans le boîtier de circuit (10 ; 110), l'étape d'introduction comprenant : la fixation du circuit dans le boîtier de circuit (10 ; 110), simultanément avec l'établissement d'une liaison thermoconductrice et directe physique (126 ; 170) entre l'au moins un composant (30, 124) et le boîtier de circuit (10 ; 110),
**caractérisé en ce que**
une surface de diffusion thermique (126d') de l'au moins un composant (124d) s'étend de manière inclinée vers le circuit (120) et l'élément de couplage thermique (170d') est prévu de manière correspondante en face de la surface de diffusion thermique inclinée (126d'), lequel s'étend depuis la paroi du boîtier vers le circuit (120) et présente, au niveau du côté tourné vers la surface de diffusion thermique (126d'), une section de surface qui est connectée de manière thermoconductrice à la surface de diffusion thermique (126d').
